# DEMANDE DE BREVET EUROPEEN

(11) **EP 0 954 206 A1**
(43) Date de publication de la demande: **03.11.1999**
(21) Numéro de dépôt: 99400991.8
(22) Date de dépôt: 22.04.1999
(51) Int. Cl.: H05B 37/02, H03K 17/96

(54) **Interrupteurs électriques**

(30) Priorité: 30.04.1998 FR 9805555
(71) Demandeur: Hirsch, Jean-Jacques, 38320 Poisat (FR)
(72) Inventeur: Hirsch, Jean-Jacques, 38320 Poisat (FR)
(74) Mandataire: Breese, Pierre

(57) **Abrégé**

La présente invention concerne un dispositif électronique de commande par effleurement comportant une électrode reliée à un circuit électronique propre à détecter de faible variations de courant, comportant une électrode destinée à venir en contact avec un substrat dans lequel est plantée un végétal, le circuit électronique étant constitué par un circuit électronique de détection du courant électrique de fuite dudit végétal vers le sol lorsqu'une personne touche une partie dudit végétal, comportant des moyens de réglage du seuil de détection.

## Description

La présente invention concerne le domaine des interrupteurs électriques.

On connaît dans l'état de la technique des interrupteurs tactiles fonctionnant sur la base de la détection de très faibles différences de potentiel entre la terre et une zone de contact reliée à un circuit électronique.

La zone de contact est généralement formée par une touche sensitive. De tels interrupteurs nécessitent la pose d'un équipement de contact spécifique.

On connaît également dans l'état de la technique des brevets proposant d'activer un équipement électrique par la détection de la variation du courant de fuite se produisant entre une feuille d'une plante et la terre.

Le brevet anglais GB2203842 et le brevet américain US4152629 divulguent par exemple un dispositif pour la commande tactile d'un appareil électrique, comportant une électrode implantée dans la terre humide dans laquelle est planté le végétal.

D'autres brevets plus généraux comme les brevet allemand 3.736.222 et américain US4.988.924 décrivent des interrupteurs tactiles utilisant des transformateurs haute-fréquence.

Le but de la présente invention est de proposer une amélioration du détecteur tactile pour l'activation d'un équipement électrique par la détection du contact entre l'utilisateur et la feuille de la plante.

Un des problèmes qui se pose avec les dispositifs de l'art antérieur est qu'il ne sont pas adaptés à tout type de végétaux. En effet, le courant de fuite nominal dépend en grande partie des caractéristiques de la plante, et notamment de la surface des feuilles et de la partie aérienne de la plante.

L'utilisation des détecteurs décrits dans l'état de la technique n'est pas satisfaisante, car ils ne tiennent pas compte de cette particularité. De ce fait le fonctionnement est aléatoire, et n'est satisfaisant que si par hasard le seuil de détection correspond aux caractéristiques de la plante avec laquelle il est utilisé.

Le premier objet de la présente invention est de remédier à cet inconvénient en proposant un dispositif permettant une adaptation aux caractéristiques d'une large variété de plantes.

A cet effet, l'invention concerne dans son acception la plus générale un dispositif électronique de commande par effleurement comportant une électrode reliée à un circuit électronique propre à détecter de faible variations de courant, comportant une électrode destinée à venir en contact avec un substrat dans lequel est plantée un végétal, le circuit électronique étant constitué par un circuit électronique de détection du courant électrique de fuite dudit végétal vers le sol lorsqu'une personne touche une partie dudit végétal. caractérisé en ce qu'il comporte des moyens de réglage du seuil de détection.

Avantageusement, le circuit électronique de détection comporte un pont diviseur formé par au moins deux résistances en parallèle, et des moyens pour isolés l'une au moins desdites résistances.

Selon une variante, le pont diviseur est formé par au moins deux résistances en parallèle, et par un interrupteur magnétique de type ILS permettant d'activer l'une au moins desdites résistances par le rapprochement d'un aimant.

Selon un mode de réalisation particulier, le circuit électronique de détection mesure la variation de la tension alternative recueillie sur une résistance placée en série entre le végétal et la phase du secteur électrique d'alimentation.

Avantageusement, le circuit électronique de détection comprend un circuit qui délivre une impulsion dont la largeur varie avec le courant de fuite et un circuit qui détecte que la largeur d'impulsion dépasse un seuil défini.

Selon un exemple d'application, le circuit de détection est associé à un gradateur électronique, un transformateur et une lampe d'éclairage basse tension placée dans le support du végétal.

Selon un autre mode de mise en oeuvre avantageux, le circuit de détection utilise un des deux fils d'alimentation de la lampe basse tension pour détecter le courant de fuite entre le végétal et le sol.

Cette solution permet d'éviter cet inconvénient en proposant un dispositif interrupteur ne nécessitant aucun organe de contact spécifique.

De préférence, le transformateur est un transformateur basse-tension.

L'invention concerne également un procédé de commande d'un circuit électrique consistant à détecter une variation de courant entre une électrode et la terre, caractérisé en ce que ladite électrode est en contact avec le substrat d'un végétal, la variation de courant de fuite se produisant par contact entre une partie dudit végétal et l'utilisateur.

Avantageusement, l'électrode est fichée dans la terre dans laquelle est plantée le végétal.

L'objet du brevet porte sur la réalisation de dispositifs de commande électronique permettant de commander par effleurement humain d'une plante ou d'un bouquet de fleurs, une lampe ou une charge électrique quelconque sans danger pour l'individu qui touche ce végétal.

Le dispositif qui est décrit peut être utilisé soit pour commander un spot basse tension placé dans la plante elle-même, soit pour commander une lampe ordinaire secteur, placée à côté de la plante.

L'utilisation d'une lampe halogène basse tension dans un support de faible dimension permet de mettre la lampe dans le pot de la plante et d'avoir un éclairage de celle-ci très décoratif. De plus, la faible tension de la lampe offre une totale sécurité contre les risques d'électrocution.

Le dispositif permet de commander d'autres charges électriques domestiques que des lampes, tels que moteur, téléviseur, radio,....

Enfin, le dispositif peut servir aussi à la détection d'intrusion (alarmes) si la partie commande est adaptée à la fermeture d'un contact pour une centrale d'alarme.

L'invention sera mieux comprise à la lecture de la description qui suit, se référant aux dessins annexés où:
- la figure 1 représente une vue schématique d'un dispositif selon l'invention ;
- la figure 2 représente une vue schématique du schéma de principe ;
- la figure 3 représente une vue schématique d'une variante de réalisation du dispositif selon l'invention ;
- La figure 4 représente une vue en coupe d'une lampe selon l'invention ;
- La figure 5 représente une variante du schéma électronique ;
- La figure 6 représente une vue d'une autre variante de réalisation ;
- La figure 7 représente une vue d'une autre variante d'une lampe selon l'invention ;
- La figure 8 représente un autre schéma du circuit électronique ;
- les figures 9 et 10 représentent des vues en coupe d'une autre variante de réalisation ;
- la figure 11 représente un schéma de principe d'une variante du circuit.

Un conducteur électrique 1, planté dans la terre du pot 2 de la plante, assure la liaison avec un détecteur 5 très sensible de courant électrique. Le dispositif détecte le courant de retour vers le neutre 8 de l'installation électrique qui passe entre la phase 9 du secteur, le détecteur 5, la plante 2 et le corps humain 3.

Le pot repose sur une surface d'isolation électrique, qui peut être une couche d'isolation recouvrant la surface inférieure du pot.

Ce courant très faible, limité par la résistance 4 d'entrée du détecteur, est compatible avec les normes de sécurité. La tension alternative 12 qui est recueillie sur la borne de la résistance 4 est normalement inférieure à un seuil 11 réglé dans le détecteur 5. Lorsqu'une personne touche la plante, cette tension augmente du fait du retour supplémentaire de courant vers le sol et sa nouvelle valeur 13 devient supérieure au seuil de déclenchement du détecteur.

Le signal électrique de sortie du détecteur sert de signal de commande pour un circuit électronique 6 tel qu'un gradateur qui via un triac et un transformateur basse tension permet de faire varier l'intensité lumineuse de la lampe 7.

Le même dispositif électronique, sans le transformateur, peut servir de gradateur pour une lampe alimentée normalement par le secteur.

Pour que le dispositif fonctionne, la plante doit être isolée du sol afin que le courant de fuite vers la terre reste inférieur au seuil de déclenchement du dispositif. De même, sa taille ne peut être très grande car le courant de fuite dans l'air du à la surface des feuilles pourrait être assez important pour déclencher le dispositif.

Enfin, si la lampe est placée dans le végétal, la chaleur dégagée doit rester faible, pour ne pas endommager les feuilles de la plante.

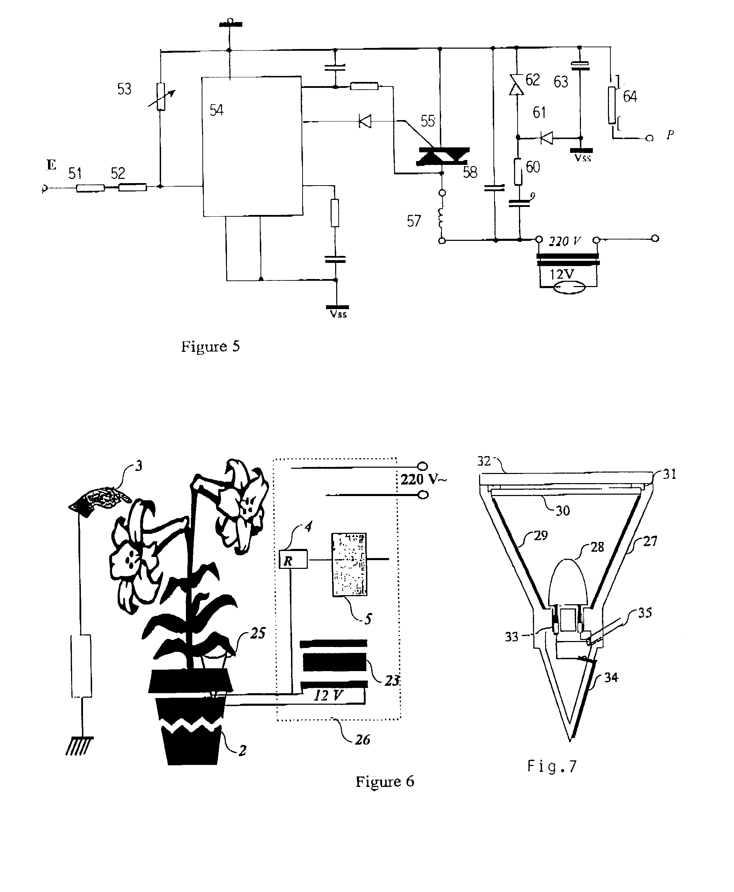

Le schéma du circuit électronique, figure 5, montre un exemple de réalisation du dispositif pour lampe halogène basse tension.

Deux résistances de forte valeur (4,7 MΩ) 51 et 52 limitent le courant de retour vers la terre à un seuil inférieur aux nomes de sécurité. Un potentiomètre 53 permet d'ajuster le seuil de déclenchement, suivant la taille de la plante.

Le circuit de détection 54 est disponible dans le commerce, il assure la fonction d'interrupteur lorsque l'effleurement de la plante est bref. Il a une fonction de gradateur lorsque l'on reste en contact avec la plante (allumage progressif puis extinction progressive et ceci de manière cyclique).

Ce circuit commande un triac 55 lequel commande le transformateur basse-tension 56. Ce transformateur est un transformateur basse-fréquence (fréquence du secteur, soit 50 ou 60 Hz). Un circuit LC 57 et 58, éliminant les parasites du triac, ainsi qu'une alimentation régulée 59 à 63 et un fusible 64 viennent compléter le dispositif.

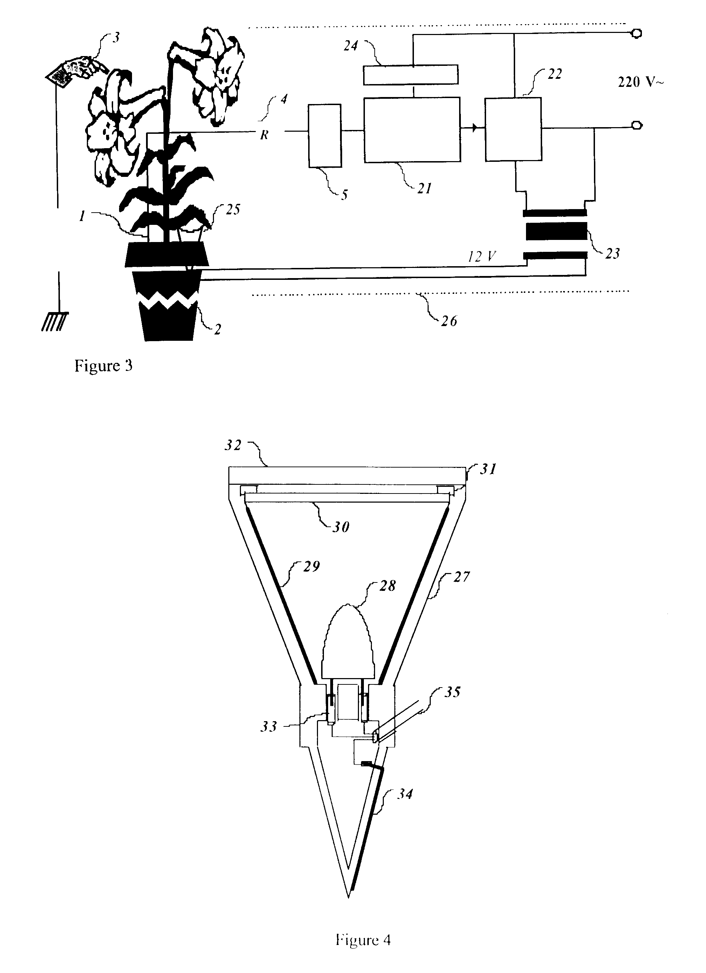

Le support de la lampe est donné sur la figure 4. La lampe basse tension 28 est placée dans un support isolant 27 fermé par un couvercle 32, un verre 30 et un joint d'étanchéité 31. Un câble 35 comprends trois conducteurs, deux pour l'alimentation de la lampe et le troisième est relié à un fil dénudé 34 qui est collé au support et assure le contact avec la terre du pot et vient se brancher sur la résistance d'entrée du circuit de détection.

Dans le cas du dispositif pour lampe basse tension, il est possible d'utiliser un des deux fils d'alimentation de la lampe pour le fil détecteur qui va dans le pot de la plante, comme le montre la figure 6. Pour cela, le transformateur doit présenter un isolement de bonne qualité entre primaire et secondaire, afin ,d'une part de respecter les normes de sécurité, et d'autre part, de ne pas ramener sur le fil détecteur, une tension trop importante pour le circuit de détection.

Cette variante offre l'avantage de réduire le nombre de fils entre le support qui est planté dans le pot et le boîtier électronique. Dans ce cas, une des deux broches de la lampe est reliée au fil conducteur qui assure le contact avec la terre du pot, comme le montre la figure 6.

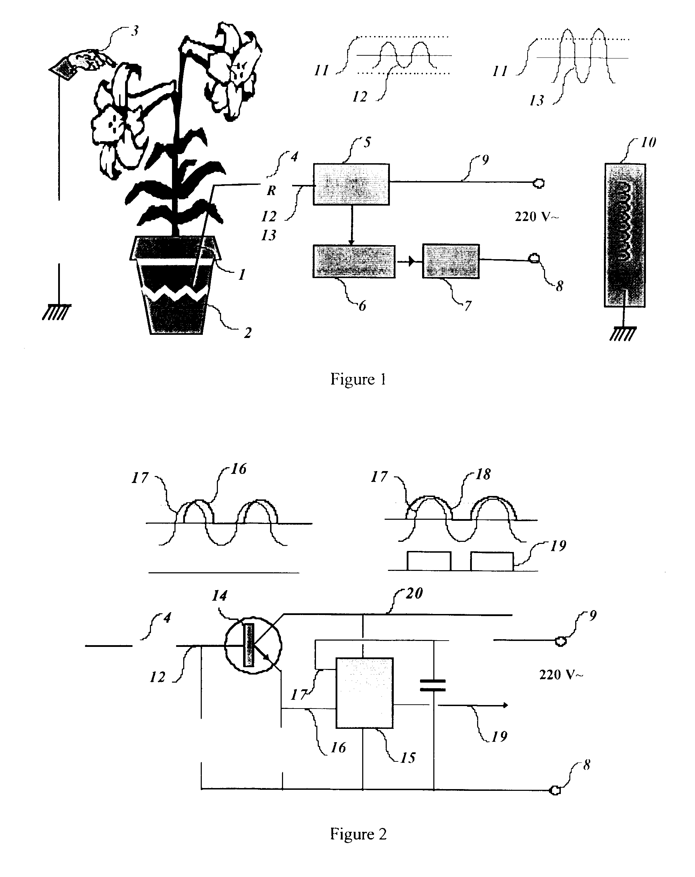

Pour la détection du contact de la plante, un principe différent peut-être utilisé, comme le montre la figure 2. Dans ce schéma, un circuit d'entrée basé sur un transistor 14 va transformer la tension détectée au borne de la résistance 4 en une impulsion 16 dont la largeur varie lorsque l'on touche la plante. Un circuit électronique comparateur 15 va détecter que la largeur de cette impulsion dépasse un seuil donné 17 et va délivrer dans ce cas, un signal 19 pour le circuit de commande 6.

Cette solution présente l'avantage de ne pas nécessiter de potentiomètre de réglage du seuil, mais est un peu plus coûteuse en terme de composants électroniques.

Enfin, la figure 7 montre un exemple de réalisation d'un support de lampe basse tension étanche, pouvant être utilisé dans un vase de fleurs rempli d'eau ou un aquarium isolé du sol.

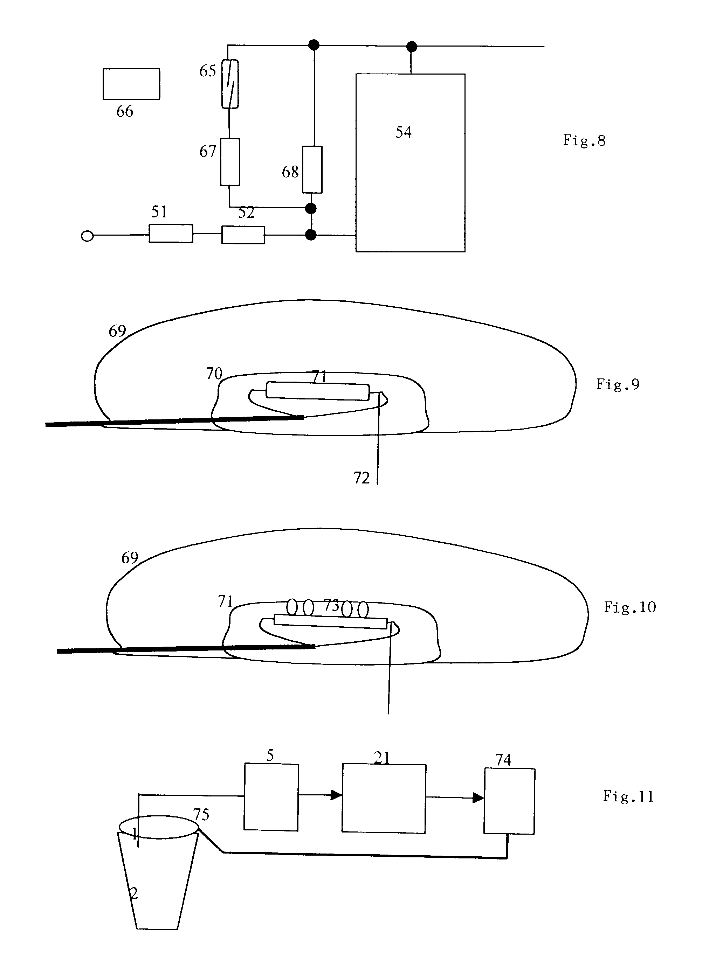

La figure 8 représente un mode de réalisation préféré. Dans le cas de plantes de grandes dimensions ou de bouquets de fleurs importants, le potentiomètre 53 doit être réajusté pour réduire la sensibilité d'entrée du circuit car le courant de fuite dans l'air des feuilles ramène une tension qui risque de faire déclencher le circuit 54 (SLB 0587).

Le circuit selon la figure 8 permet de remplacer le potentiomètre par un pont diviseur qui peut prendre deux valeurs, l'une correspondant à la sensibilité normale, l'autre correspondant à une réduction de sensibilité pour les grandes plantes. Pour cela, un aimant 66, qui agit à distance de l'ampoule relais ILS 65 vient fermer le contact qui commande une résistance 67 qui vient se placer en parallèle avec la résistance 68 du pont diviseur d'entrée. Cette solution apporte plusieurs avantages :
a) la commande par l'aimant se faisant sans contact avec le circuit, l'isolement vis à vis du circuit de commande est très élevé. Lorsque l'aimant n'est pas mis en place, le relais ILS est ouvert. Lorsque l'aimant se trouve placé à 10 mm du relais ILS, celui-ci colle et les contacts se ferment, la sensibilité du circuit s'en, trouve réduite. Les résistances 51,52,67 et 68 seront choisies pour offrir une zone de recouvrement. Par exemple, pour des valeurs de 4,7 Mohm des résistances 51 et 52, la valeur optimale pour 68 est de 330 Kohm et celle de 67 est de 680 Kohm.
b) le potentiomètre nécessite un réglage en sortie de la chaîne de fabrication de la carte de commande, avec la solution ILS, il suffit d'un test GO/NO GO. Ceci réduit le coût de test du circuit.
c) Si l'on veut que l'utilisateur final puisse accéder au potentiomètre pour réduire la sensibilité dans le cas de grandes plantes, il faut lui donner un accès via un tournevis ou via un bouton. Ceci signifie qu'un trou dans le boîtier qui abrite la carte doit être prévu, d'ou des difficultés pour assurer la sécurité et l'étanchéité. La solution avec le relais ILS contourne cette difficulté, car l'aimant agit au travers du boîtier, si celui-ci n'est pas métallique.

Les circuits électroniques et électriques sont encaspulés dans une résine isolant, le contacteur ILS étant placé à proximité de la surface d'encapsulation.

Le spot basse tension 25 décrit figure 4 est basé sur une technologie de source lumineuse Halogène, laquelle présente l'inconvénient de dégager de la chaleur. Pour éviter de brûler les feuilles des plantes la puissance de la lampe 28 doit être faible et le spot doit évacuer la chaleur vers le bas. Toutefois ceci risque d'assécher la terre du pot.

Il a été découvert qu'avec des lampes au Xénon, la chaleur dégagée est bien moindre (dans un rapport 3 à 5). Avec cette technologie de lampe, il devient possible de faire un galet lumineux en verre soufflé ou en résine ou en plexiglas, comme le montre la figure 9.

Le galet 69, si il est en verre, peut être sablé avec un motif ou un logo pour assurer une diffusion de la lumière de la lampe xénon 71 qui rayonne dans toutes les directions et est placée dans la cavité 70 du galet. Un des fils d'alimentation 72, assure le contact avec la terre.

Le galet peut être équipé de diodes LED comme le montre la figure 10. Pour cela un circuit imprimé standard permet de mettre plusieurs LED 73 en parallèle et d'accroître la quantité de lumière émise.

Dans ce cas, le circuit secondaire du transformateur 23 doit alimenter un pont redresseur de courant afin d'alimenter les LED en tension continue.

Il est possible d'obtenir des effets de couleur en changeant le sens de passage du courant dans les LED, en effet certaines LED sur le marché sont capables d'émettre une lumière verte ou rouge suivant le sens de passage du courant.

Les composants électro-luminescent sont capables de générer une lumière sans dégagement de chaleur. Ces composants sont aujourd'hui utiliser pour l'éclairage rétro-réflechissant des écrans des ordinateurs portables ou encore pour les marches d'escalier dans les salles de cinéma.

Cette technologie fonctionne avec une tension alternative d'environ 30 volts qui ne présente pas de danger, un courant très faible, et ont la particularité de changer de fréquence d'émission des ondes lumineuses en fonction de la fréquence de la tension de commande.

En association avec un circuit capable de générer une tension d'amplitude constante mais de fréquence variable (VCO voltage control oscillator) il devient possible de commander la couleur et la marche-arrêt de la source lumineuse suivant la revendication 1 de ce brevet.

Le schéma de principe du circuit est donné en figure 11.

Le circuit de commande 21 qui donne une impulsion dont la position dans l'alternance du secteur dépend du toucher de la plante dans le pot 2, commande un circuit VCO 74 qui va délivrer une tension alternative dont la fréquence varie en proportion de la position de l'impulsion sortant de 21. La sortie de ce circuit VCO vient commander la source de lumière électro-luminescente 75 qui peut avoir une forme d'anneau en deux parties pour venir entourer la plante.

## Revendications

1. Dispositif électronique de commande par effleurement comportant une électrode reliée à un circuit électronique propre à détecter de faible variations de courant, comportant une électrode destinée à venir en contact avec un substrat dans lequel est plantée un végétal, le circuit électronique étant constitué par un circuit électronique de détection du courant électrique de fuite dudit végétal vers le sol lorsqu'une personne touche une partie dudit végétal, caractérisé en ce qu'il comporte des moyens de réglage du seuil de détection.

2. Dispositif selon la revendication 1 caractérisé en ce que le circuit électronique de détection comporte un pont diviseur formé par au moins deux résistances (67, 68) en parallèle, et des moyens (65) pour isolés l'une au moins desdites résistances.

3. Dispositif selon la revendication 2 caractérisé en ce que le pont diviseur est formé par au moins deux résistances (67, 68) en parallèle, et par un interrupteur magnétique de type ILS (65) permettant d'activer l'une au moins desdites résistances (67) par le rapprochement d'un aimant.

4. Dispositif selon l'une au moins des revendications 1 à 3 caractérisé en ce que le circuit électronique de détection mesure la variation de la tension alternative recueillie sur une résistance placée en série entre le végétal et la phase du secteur électrique d'alimentation.

5. Dispositif selon l'une au moins des revendications 1 à 4 caractérisé en ce que circuit électronique de détection comprend un circuit qui délivre une impulsion dont la largeur varie avec le courant de fuite et un circuit qui détecte que la largeur d'impulsion dépasse un seuil défini.

6. Dispositif selon la revendication 1 caractérisé en ce que le circuit de détection est associé à un gradateur électronique, un transformateur et une lampe d'éclairage basse tension placée dans le support du végétal.

7. Dispositif selon l'une au moins des revendications 1 à 6 caractérisé en ce que le circuit de détection utilise un des deux fils d'alimentation de la lampe basse tension pour détecter le courant de fuite entre le végétal et le sol.

8. Dispositif selon la revendication 1 caractérisé en ce que le transformateur (15) est un transformateur basse-tension.

9. Procédé de commande d'un circuit électrique consistant à détecter une variation de courant entre une électrode et la terre, caractérisé en ce que ladite électrode est en contact avec le substrat d'un végétal, la variation de courant de fuite se produisant par contact entre une partie dudit végétal et l'utilisateur.

10. Procédé de commande d'un circuit électrique selon la revendication 9, caractérisé en ce que l'électrode est fichée dans la terre dans laquelle est plantée le végétal.
